# EUROPEAN PATENT SPECIFICATION

(11) **EP 0 957 580 B1**
(45) Date of publication and mention of the grant of the patent: **02.04.2008**
(21) Application number: 99108820.4
(22) Date of filing: 04.05.1999
(51) Int. Cl.: H03H 17/06

(54) **Method and apparatus for sampling-rate conversion of audio signals**
Verfahren und Vorrichtung zur Abtastratenumsetzung von Audiosignalen
Procédé et dispositif pour la conversion de taux d'échantillonage de signaux audio

(30) Priority: 15.05.1998 EP 98108860
(43) Date of publication of application: 17.11.1999
(73) Proprietor: THOMSON, 92100 Boulogne-Billancourt (FR)
(72) Inventor: Schmidt, Jürgen, 31515 Wunstorf (DE); Schröder, Ernst F., 30655 Hannover (DE)
(74) Representative: Hartnack, Wolfgang

(56) References cited:
- EP-A- 0 692 881
- WO-A-86/02217
- DE-C- 19 510 226
- US-A- 5 610 942
- B. EDLER: "Aliasing Reduction in Sub-Bands of Cascaded Filter Banks with Decimation" ELECTRONICS LETTERS, vol. 28, no. 12, 4 June 1992 (1992-06-04), pages 1104-1106, XP000304622 STEVENAGE GB

## Description

The invention relates to a method and an apparatus for sampling-rate conversion of audio signals, especially for sampling-rate conversion at the decoding of MPEG audio or DOLBY AC-3 encoded signals.

### Prior art

Today many different sampling rates exist like 44.1 kHz for Compact Disc, 32 kHz and 48 kHz for DAT, Digital-VCR or Sat-TV and 48 kHz or 96 kHz for DVD audio signals. Therefore, a change of the sampling-rate is necessary if the internal sampling-rate of the decoder of a playback or recording device differs from the sampling-rate of the audio signal to be decoded.

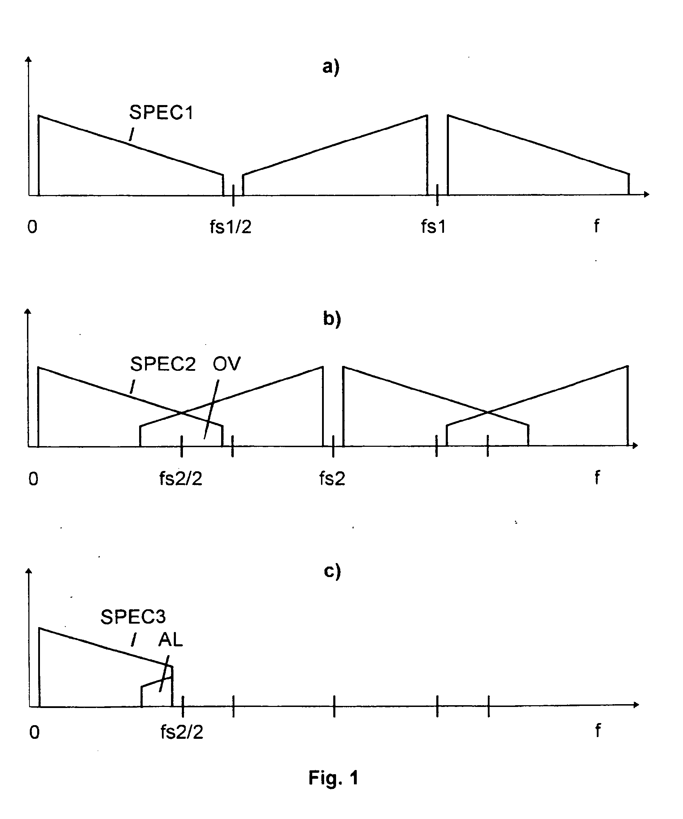

Generally, performing sampling-rate conversion from higher to lower sampling frequency (e.g. 48 to 32 kHz) results in aliasing like shown in Fig. 1. The schematic spectrum SPEC1 of the digital signal sampled with fs1 is shown in Fig. 1a). After re-sampling with fs2 < fs1, the digital signal has a spectrum SPEC2 according to Fig. 1b). The overlapping regions OV already show that aliasing errors have occurred. After consecutive D/A conversion and appropriate low-pass filtering an analog signal with spectrum SPEC3 shown in Fig. 1c) results, which contains severe alias distortion AL.

It is known e.g. from WO-A-86/02217 to use a low-pass filter, known as anti-alias filter, for reducing or totally avoiding this alias distortion by decreasing or removing spectral contents above fs2/2 from the digital signal. However, calculating the anti-alias filter requires additional processing power which is desirable to save.

### Invention

The invention is based on the object of specifying a method for sampling-rate conversion of audio signals without the use of an anti-alias filter. This object is achieved by means of the method specified in claim 1.

The invention is based on the further object of specifying an apparatus for carrying out the method according to the invention. This object is achieved by means of the apparatus specified in claim 5.

In principle, the method as defined in claim 1 for sampling-rate conversion of audio signals, which are sampled with a first sampling frequency before spectral encoding and are re-sampled after spectral decoding with a second sampling frequency which is smaller than the first sampling frequency, consists in the fact that the signal parts beyond an upper frequency limit are reduced, advantageously suppressed, at spectral decoding resulting in a bandwidth of the signal to be re-sampled which is less than half of the second sampling frequency.

This method not only totally removes the processing power needed for calculating an anti-alias filter, but also limits the decoding work needed.

In an advantageous manner, the spectral encoding algorithm uses subband coding.

In this case, it may be particularly advantageous if the subband coding algorithm corresponds to the MPEG standard and the decoding is limited to the first 20 subbands.

In a further advantageous development the spectral encoding algorithm uses a transformation into the frequency domain, e.g. DFT.

In this case, it may be particularly advantageous if the spectral encoding algorithm corresponds to the AC-3 standard and spectral lines are reduced or set to zero at decoding.

In principle, the apparatus as defined in claim 5 consists in a sample rate converter for sampling-rate conversion of a digital audio signal from a first sampling-rate to a second sampling-rate, consists in the fact that a frequency-to-time converter suppresses the signal parts of the digital audio signal beyond an upper frequency limit resulting in a bandwidth of the signal to be re-sampled which is equal to or less than half of the second sampling frequency.

The invention may be particularly advantageous if the apparatus is part of an audio decoder for decoding audio data according to any MPEG audio or the DOLBY AC-3 standard.

### Drawing

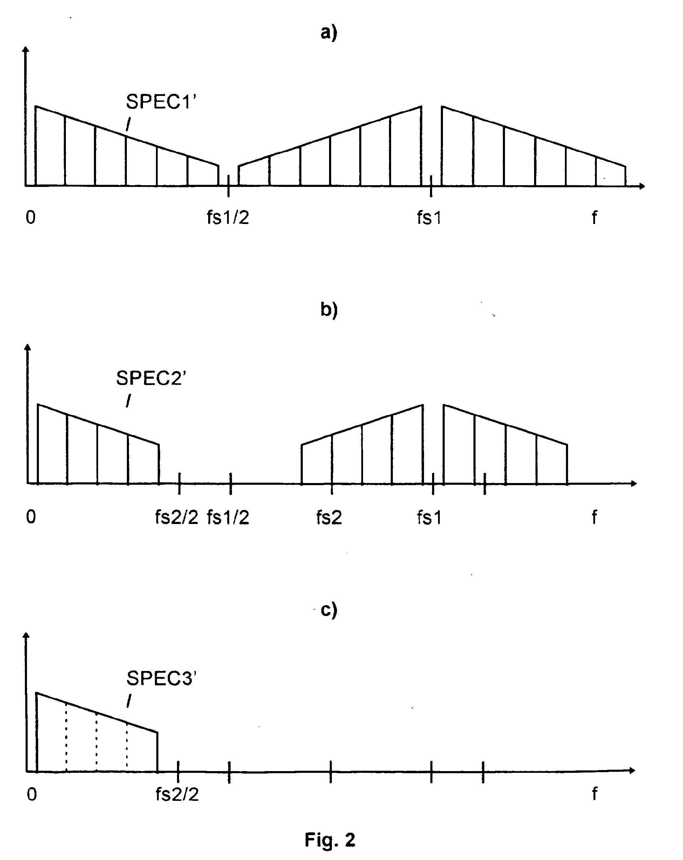

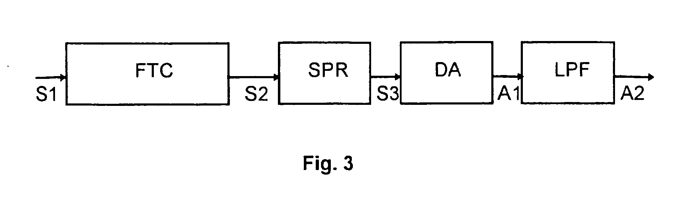

Exemplary embodiments of the invention are described with reference to Figures 2 and 3. These show in:
- Fig. 2: a) a schematic example spectrum with 6 subbands,
b) the example spectrum after decoding,
c) the analog output after subsequent D/A conversion and low pass filtering;
- Fig. 3: a block diagram of a decoding arrangement according to the invention.

### Exemplary embodiments

Figure 2 illustrates the method according to the invention for MPEG coded audio signals. As specified in the ISO/IEC 11172-3 standard, which defines the coding for MPEG1 audio signals and which is also valid for MPEG2 audio signals specified in the following ISO/IEC 13818-3 standard, subband coding is performed for data reduction. The subband coding splits up the audio spectrum into 32 different frequency bands to exploit the fact that the human ear can be modeled as a multiband spectrum analyzer. Each of the 32 subbands has a bandwidth which is 1/32 of half the sampling rate, i.e. 750 Hz for a sampling rate of 48 kHz. The band-splitting process corresponds to a time-to-frequency conversion and is performed by using a special subband coding algorithm for calculating a filterbank. The following quantization and data reduction is achieved by applying a psychoacoustic model. At the decoding end the bands have to be recombined into the original broadband signal by the inverse frequency-to-time conversion.

After frequency-to-time conversion a digital signal sampled at fs1 (e.g. 48 kHz) has a spectrum SPEC1' as shown in Fig. 2a where for clarity reasons only 6 subbands are shown. The previous frequency domain representation is shown as sections in the schematic spectrum. When the frequency-to-time conversion is done in a way which suppresses the signal contents in the upper frequency range, a spectrum SPEC2' as shown in Fig. 2b having only 4 subbands results. After subsequent D/A conversion and suppressing of the harmonic signals by a subsequent low-pass filter finally the spectrum SPEC3' of Fig. 2c results without any alias distortions.

A similar approach is possible for Dolby AC-3 which uses transform coding. At transform coding a time-windowed version of the input signal is transformed into the frequency domain by a time-to-frequency transformation such as a DFT (Discrete Fourier Transformation), a DCT (Discrete Cosine Transformation) or specially modified versions thereof. Values in the frequency domain are then quantized by using psychoacoustic phenomenons, coded and transmitted. In the decoder the frequency values are expanded and re-transformed into the time domain. In this case the signal contents in the upper frequency range can be reduced or suppressed during the frequency-to-time conversion by setting spectral lines to reduced values or even to zero.

Fig. 3 shows a block diagram of a decoding arrangement according to the invention. The encoded signal S1 with a sampling-rate fs1 is first fed to a frequency-to-time converter FTC which performs the conversion in a way which suppresses the signal contents in the upper frequency range. The resulting signal S2 has a spectrum as shown in Fig. 2b and is fed to a sample rate converter SPR. The sample rate converter SPR performs the above described sampling-rate conversion from the first sampling-rate fs1 to the second sampling-rate fs2 and yields a signal S3. This digital signal S3 is converted into an analog signal A1 by the D/A converter DA. Finally a low pass filter LPF at fs2/ yields the output signal A2.

The invention can advantageously be used within a TV receiver which is connected with a DVD player. Encoded DVD audio signals use sampling frequencies of 48 or 96 kHz. For various purposes it is desirable to do the decoding of the AC-3 or MPEG audio signals not in the DVD player but in the connected TV receiver, which typically uses internal sampling rates of 32 kHz and a frequency range for playback of 15 kHz. The sampling rate conversion can be performed according to the invention without anti-alias filter by not decoding the signal parts beyond the new upper limit frequency. Generally, for MPEG audio signals according to the ISO/IEC 11172-3 standard using the mentioned sampling rates and typical bit rates, only 27 of the 32 subbands are decoded. Therefore, by using the invention, the upper 7 of the 27 subbands are not to be decoded, i.e. the decoding is limited to the first 20 subbands (20 x 750 Hz = 15 kHz).

Furthermore, the invention can be used in all other devices for recording or reproduction of digitally coded audio signals such as e.g. set top boxes, all kinds of tape recorders, computer devices. Finally, the invention is not restricted to MPEG or DOLBY AC-3 coded audio signals but also applies to audio signals coded by other bit-rate saving algorithms which are based on the signal representation by its spectral contents.

## Claims

1. Method for sampling-rate conversion of digital audio signals, comprising:
receiving a frequency domain representation of an encoded audio signal, wherein the audio signal was sampled at a first sampling frequency (fs1) and the sampled audio signal was converted from the time domain to the frequency domain during encoding performed for data reduction;
reducing portions of said received audio signal representing frequencies above half of a second sampling frequency (fs2) during decoding said received audio signal; and
re-sampling said decoded digital audio signals with said second sampling frequency (fs2) wherein said second sampling frequency (fs2) is smaller than said first sampling frequency (fs1).

2. Method according to claim 1 wherein said encoded audio signal has been encoded using a subband coding system and at decoding an inverse system is used.

3. Method according to claim 2 wherein the encoding and decoding of the digital audio signal corresponds to an MPEG audio standard and the decoding is limited to the first 20 subbands.

4. Method according to claim 1 wherein the encoding and decoding of the audio signal corresponds to the DOLBY AC-3 standard and spectral lines are set to reduced values or to zero at decoding.

5. Apparatus for sampling-rate conversion of digital audio signals, comprising:
means for receiving a frequency domain representation of an encoded audio signal, wherein the audio signal was sampled at a first sampling frequency (fs1) and the sampled audio signal was converted from the time domain to the frequency domain during encoding performed for data reduction;
means (FTC) for reducing portions of said received audio signal representing frequencies above half of a second sampling frequency (fs2) during decoding said received audio signal; and
means (SPR) for re-sampling said decoded digital audio signals with said second sampling frequency (fs2) wherein said second sampling frequency (fs2) is smaller than said first sampling frequency (fs1).

6. Apparatus according to claim 5 wherein this apparatus is part of an audio decoder for decoding audio data according to an MPEG audio or the DOLBY AC-3 standard.

## Patentansprüche

1. Verfahren zur Abtastraten-Umsetzung von digitalen Audiosignalen, umfassend:
Empfangen einer Frequenzbereichs-Darstellung eines kodierten Audiosignals, wobei das Audiosignal mit einer ersten Abtastfrequenz (fs1) abgetastet wurde und das abgetastete Audiosignal während der zur Datenverminderung ausgeführten Kodierung aus dem Zeitbereich in den Frequenzbereich umgesetzt wurde;
Vermindern von Teilen des empfangenen Audiosignals, die Frequenzen oberhalb der Hälfte einer zweiten Abtastfrequenz (fs2) darstellen, während der Dekodierung des empfangenen Audiosignale; und
Neu-Abtasten der dekodierten digitalen Audiosignale mit der zweiten Abtastfrequenz (fs2), wobei die zweite Abtastfrequenz (fs2) kleiner als die erste Abtastfrequenz (fs1) ist.

2. Verfahren nach Anspruch 1, bei dem das kodierte Audiosignal unter Verwendung eines Subband-Kodiersystems kodiert worden ist und bei der Dekodierung ein inverses System verwendet wird.

3. Verfahren nach Anspruch 2, bei dem die Kodierung und Dekodierung des digitalen Audiosignals einer MPEG-Audio-Norm entspricht und die Dekodierung auf die ersten 20 Subbänder beschränkt ist.

4. Verfahren nach Anspruch 1, bei dem die Kodierung und Dekodierung des Audiosignals der DOLBY-AC-3-Norm entspricht und Spektrallinien bei der Dekodierung auf verminderte Werte oder auf Null gesetzt werden.

5. Vorrichtung zur Abtastraten-Umsetzung von digitalen Audiosignalen, umfassend:
Mittel zum Empfangen einer Frequenzbereichs-Darstellung eines kodierten Audiosignals, wobei das Audiosignal mit einer ersten Abtastfrequenz (fs1) abgetastet wurde und
das abgetastete Audiosignal während der zur Datenverminderung ausgeführten Kodierung aus dem Zeitbereich in den Frequenzbereich umgesetzt wurde;
Mittel (FTC) zur Verminderung von Teilen des empfangenen Audiosignals, die Frequenzen oberhalb der Hälfte einer zweiten Abtastfrequenz (fs2) darstellen, während der Dekodierung des empfangenen Audiosignals; und
Mittel (SPR) zum Neu-Abtasten des dekodierten digitalen Audiosignals mit der zweiten Abtastfrequenz (fs2), wobei die zweite Abtastfrequenz (fs2) kleiner als die erste Abtastfrequenz (fs1) ist.

6. Vorrichtung nach Anspruch 5, bei der diese Vorrichtung Teil eines Audio-Dekodierers zum Dekodieren von Audiodaten nach einer MPEG-Audio- oder der DOLBY-AC-3-Norm ist.

## Revendications

1. Procédé pour la conversion de taux d'échantillonnage de signaux audio numériques, comprenant :
une réception d'une représentation de domaine fréquentiel d'un signal audio codé, où le signal audio a été échantillonné à une première fréquence d'échantillonnage (fs1) et le signal audio échantillonné a été converti du domaine temporel au domaine fréquentiel lors d'un codage réalisé pour une réduction de données ;
une réduction de parties dudit signal audio reçu représentant des fréquences supérieures à la moitié d'une seconde fréquence d'échantillonnage (fs2) lors d'un décodage dudit signal audio reçu ; et
un rééchantillonnage desdits signaux audio numériques décodés avec ladite seconde fréquence d'échantillonnage (fs2) où ladite seconde fréquence d'échantillonnage (fs2) est inférieure à ladite première fréquence d'échantillonnage (fs1).

2. Procédé selon la revendication 1, dans lequel ledit signal audio codé a été codé à l'aide d'un système de codage en sous-bandes et lors du décodage un système inverse est utilisé.

3. Procédé selon la revendication 2, dans lequel le codage et le décodage du signal audio numérique correspondent à une norme audio MPEG et le décodage se limite aux 20 premières sous-bandes.

4. Procédé selon la revendication 1, dans lequel le codage et le décodage du signal audio correspondent à la norme DOLBY AC-3 et des lignes spectrales sont définies sur des valeurs réduites ou sur zéro lors du décodage.

5. Appareil pour la conversion de taux d'échantillonnage de signaux audio numériques, comprenant :
un moyen permettant de recevoir une représentation de domaine fréquentiel d'un signal audio codé, où le signal audio a été échantillonné à une première fréquence d'échantillonnage (fs1) et le signal audio échantillonné a été converti du domaine temporel au domaine fréquentiel lors d'un codage réalisé pour une réduction de données ;
un moyen (FTC) permettant de réduire des parties dudit signal audio reçu représentant des fréquences supérieures à la moitié d'une seconde fréquence d'échantillonnage (fs2) lors d'un décodage dudit signal audio reçu ; et
un moyen (SPR) permettant de rééchantillonner lesdits signaux audio numériques décodés avec ladite seconde fréquence d'échantillonnage (fs2) où ladite seconde fréquence d'échantillonnage (fs2) est inférieure à ladite première fréquence d'échantillonnage (fs1).

6. Appareil selon la revendication 5, où cet appareil fait partie d'un décodeur audio permettant de décoder des données audio conformément à une norme audio MPEG ou à la norme DOLBY AC-3.
